Europäisches Patentamt

European Patent Office

Office européen des brevets

(19)

(11) Veröffentlichungsnummer: **0 205 747**
**A1**

# (12) EUROPÄISCHE PATENTANMELDUNG

(21) Anmeldenummer: 86102344.8

(22) Anmeldetag: 24.02.86

(51) Int. Cl.⁴: **G 01 R 31/16**

(30) Priorität: 07.03.85 CH 1030/85

(43) Veröffentlichungstag der Anmeldung: 30.12.86
Patentblatt 86/52

(84) Benannte Vertragsstaaten: **CH DE FR GB IT LI SE**

(71) Anmelder: **BBC Aktiengesellschaft Brown, Boveri & Cie., Haselstrasse, CH-5401 Baden (CH)**

(72) Erfinder: **Ari, Niyazi, Dr., Landstrasse 154, CH-5415 Nussbaumen (CH)**
Erfinder: **Hansen, Diethard, Dr., Bahnhofstrasse 39a, CH-8965 Berikon (CH)**
Erfinder: **Schär, Hans, Dr., Solothurnerstrasse 41, CH-4053 Basel (CH)**

(54) Einrichtung zur Prüfung elektrischer oder elektronischer Systeme mit elektro-magnetischen Pulsen.

(57) Bei dieser Einrichtung wird eine gasgefüllte Prüfzelle (1) verwendet, welche das Prüfobjekt (8) aufnimmt und an welche ein Impulsgenerator angeschlossen ist. Die Prüfzelle (1) ist über ihre gesamte Länge als Koaxialleitung mit einem bandförmigen Innenleiter (3) und einem runden Außenleiter (2) ausgebildet. Flächenparallel zum Innenleiter (3) ist innerhalb des Außenleiters (2) in einem mindestens der doppelten Höhe (H) des Prüfobjekts (8) entsprechenden Abstand (h) eine mit dem Außenleiter (2) verbundene bandförmige Potentialplatte (4) angeordnet. Der genannte Abstand (h) ist auch größer als der kürzeste Abstand (a) des Innenleiters (3) vom Außenleiter (2). Das Verhältnis der Summe aus der Breite (b) des Innenleiters (3) und seiner Dicke (d) zum Durchmesser (D) des Außenleiters (2) ist so gewählt, daß es zwischen 0,4 und 0,9 beträgt.

0205747

26/85

7.3.85

La/SC

- 1 -

Einrichtung zur Prüfung elektrischer oder elektronischer
Systeme mit elektro-magnetischen Pulsen

Die Erfindung betrifft eine Einrichtung gemäss dem Oberbegriff des Anspruchs 1.

Einrichtungen dieser Art sind beispielsweise bekannt aus
Artikeln von M.L. Crawford "IEEE Transactions on Instrumentation and Measurement", Vol. IM-26, No. 3, September
1977, S. 225-230 sowie C.E. Baum "IEEE Transactions on
Electromagnetic Compatibility", Vol. EMC-20, No. 1, February 1978, S. 35-53.

Elektro-magnetische Pulse (EMP) können bei ausreichend
grosser Amplitude und schneller Anstiegszeit Schäden in
elektrischen Systemen aller Art, vornehmlich in empfindlichen elektronischen Geräten anrichten. Besonders im
Falle von sogenannten nuklearen elektro-magnetischen Pulsen
(NEMP), welche durch Zündung eines nuklearen Sprengsatzes
erzeugt werden, liegen die typischen Werte solcher zerstörerischen Feldamplituden bei Feldstärken von 50000 V/m bzw.
130 A/m bei nur wenigen ns Anstiegszeit.

0205747
26/85

Um sicher wirkende Schutzvorrichtungen für elektrische Systeme aller Art entwickeln zu können, sind Simulationseinrichtungen erforderlich, in welchen elektro-magnetische Pulse mit einem mehrfachen der NEMP-Feldstärken erzeugt werden können. Für Sonderprüfungen sind bis zu zehnfache NEMP-Feldstärken erwünscht. Die Erzeugung von Pulsen mit derart hohen Feldstärken ist mit den bekannten Einrichtungen nicht möglich.

Die Erfindung, wie sie im Anspruch 1 gekennzeichnet ist, löst die Aufgabe, eine Einrichtung der eingangs genannten Art zu schaffen, in welcher elektro-magnetische Pulse mit Feldstärken oberhalb der typischen NEMP-Feldstärken und wenigen ns Anstiegszeit erzeugt werden können.

Die Vorteile der Erfindung sind im wesentlichen darin zu sehen, dass die Prüfeinrichtung im Verhältnis zur Grösse des zu prüfenden Objekts sehr kompakt aufgebaut werden kann. Durch die Ausbildung der Prüfeinrichtung als Koaxialleitung mit einem runden Aussenleiter, werden insbesondere Feldverzerrungen und Streuungen an rechteckförmigen Aussenwänden wie bei den vorstehend zitierten Einrichtungen nach dem Stand der Technik vermieden. Bedingt durch ihre koaxiale Form lässt sich die Prüfzelle auch leicht an koaxiale Impulsgeneratoren anflanschen. Durch die Bemessung des Verhältnisses der Summe aus der Breite des Innenleiters und seiner Dicke zum Durchmesser des Aussenleiters zwischen 0,4 und 0,9 lässt sich in vorteilhafter Weise eine charakteristische Impedanz der Prüfzelle zwischen etwa 100 Ohm und 40 Ohm kontrolliert einstellen. Die charakteristische Impedanz variiert zwischen diesen Werten recht gut linear mit dem genannten Verhältnis.

Vorteilhafte Ausgestaltungen der Erfindung sind in den Unteransprüchen gekennzeichnet.

Durch die Verwendung von $SF_6$ als Isolationsgas, insbesondere unter Ueberdruck, lässt sich die Spannungsfestigkeit der Prüfzelle wesentlich erhöhen. Durch Füllung der Prüfzelle mit einem elektrisch isolierenden Gas bei Unter- oder Ueberdruck, bei verschiedenen Temperaturen oder Feuchtigkeiten, etc. lassen sich verschiedene klimatische Bedingungen simulieren. Die Unterteilung des Innenraums der Prüfzelle durch die Potentialplatte in zwei Teilräume hat den Vorteil, dass sich das elektromagnetische Feld nur in einem der beiden Teilräume ausbreiten kann, nämlich in dem Teilraum, in welchem der Innenleiter angeordnet ist. Der andere Teilraum ist feldfrei und bildet damit in geradezu idealer Weise einen Kabelschacht für die Zuführung von Anschlussleitungen zum Prüfobjekt. Werden zusätzlich im Bereich der in diesem Falle erforderlichen Durchführungen der Anschlussleitungen durch die Potentialplatte Filter in die Anschlussleitungen geschaltet und diese nach ihrer Durchführung durch die Potentialplatte auf dem kürzest möglichen Weg zum Prüfobjekt geführt, so können Einstreuungen in die Anschlussleitungen praktisch vermieden werden.

Im folgenden wird die Erfindung anhand der Zeichnung näher erläutert.

Es zeigt:

Fig. 1   in stark vereinfachter schematischer Darstellung einen Längsschnitt durch eine Einrichtung nach der Erfindung und

Fig. 2   einen Querschnitt durch eine solche Einrichtung.

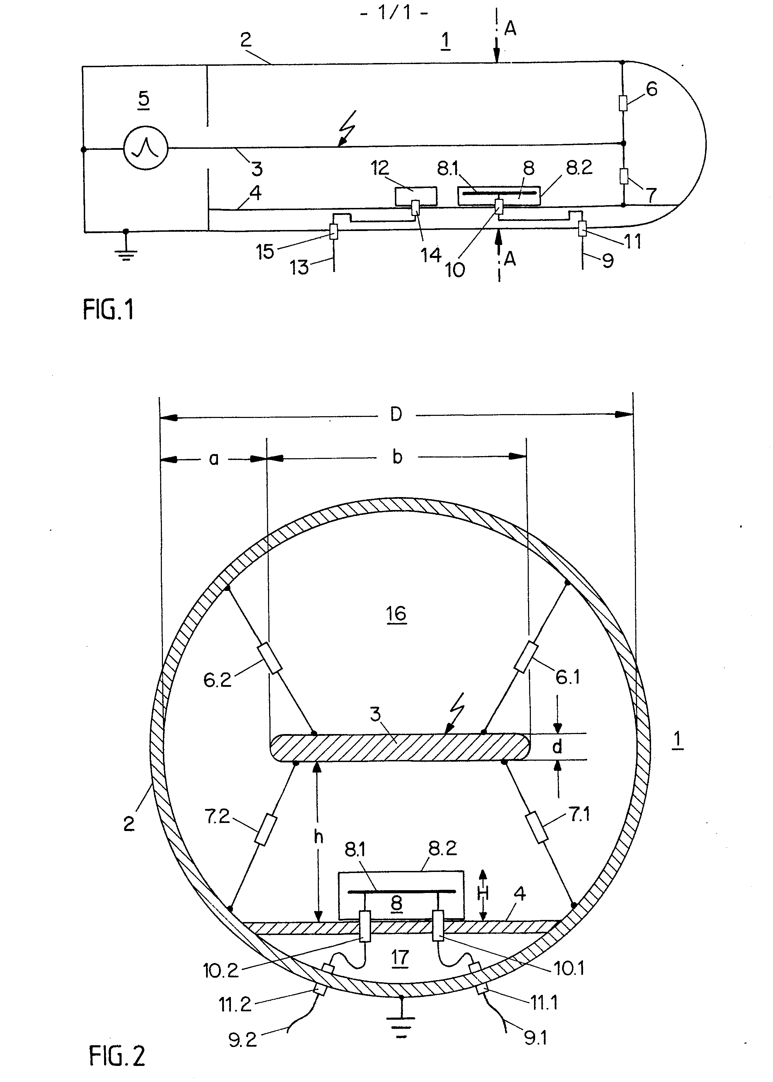

In Fig. 1 ist mit 1 eine Prüfzelle bezeichnet, welche einen runden Aussenleiter 2 und koaxial dazu einen bandförmigen Innenleiter 3 aufweist. Parallel zum Innenleiter 3 ist in der Prüfzelle 1 eine mit dem Aussenleiter 2 elektrisch verbundene Potentialplatte 4 vorgesehen. Diese ist vorzugsweise als ebene Auflagefläche für die zu prüfenden Objekte im unteren Teil der Prüfzelle 1 angeordnet. Die Prüfzelle 1 ist mit einem beliebigen Isolationsgas wie z.B. Luft oder $SF_6$ unter Ueber- oder Unterdruck füllbar. Auf der in Fig. 1 linken Seite ist an die Prüfzelle 1 ein koaxialer Impulsgenerator 5 angeflanscht. Auf der gegenüberliegenden, in Fig. 1 also rechten Seite, ist die Prüfzelle 1 mit Widerständen 6 und 7 abgeschlossen, deren Gesamtwiderstand vorzugsweise der charakteristischen Impedanz der Prüfzelle 1 bzw. der sie bildenden Koaxialleitung aus Aussenleiter 2 und Innenleiter 3 entspricht. Mit 8 ist in Fig. 1 ein Prüfobjekt bezeichnet, welches auf der Potentialplatte 4 aufliegt. Das beispielsweise dargestellte Prüfobjekt 8 besteht aus einer mit elektronischen Bauelementen bestückten Leiterplatte 8.1 in einem Gehäuse 8.2. Vom Prüfobjekt 8 ist eine Anschlussleitung 9 über eine Durchführung 10 durch die Potentialplatte 4 und über eine gasdichte Durchführung 11 durch den Aussenleiter 2 nach aussen geführt. In der Nähe des Prüfobjekts 8 ist in der Prüfzelle 1 ein Feldsensor 12 angeordnet, von welchem, wie vom Prüfobjekt 8, eine Anschlussleitung 13 über Durchführungen 14 und 15 durch die Potentialplatte 4 und den Aussenleiter 2 nach aussen geführt ist. Der Feldsensor 12 dient zur Messung der elektrischen und/oder der magnetischen Feldstärke in der Nähe des Prüfobjekts 8. Selbstverständlich können auch getrennte Sensoren zur Bestimmung der elektrischen und der magnetischen Feldstärke verwendet werden. Auch dürften in der Praxis mehr Anschlussleitungen als die beiden in Fig. 1 dargestellten Leitungen 9 und 14 erforderlich sein. Entsprechend sind in Fig. 2, in der ein Querschnitt durch die Prüfzelle 1 nach Fig. 1 auf der Höhe der in Fig. 1 eingezeichneten Schnittlinie A-A dargestellt ist, zwei Anschlussleitungen 9.1 und 9.2 gezeichnet, die vom Prüfobjekt 8 über Durchführungen 10.1 und 11.1 bzw. 10.2 und 11.2 nach aussen geführt sind.

Auch sind in Fig. 2 die Widerstände 6 und 7 nach Fig. 1 jeweils in Widerstände 6.1 und 6.2 bzw. 7.1 und 7.2 unterteilt. Ansonsten entsprechen alle Teile von Fig. 2 denen von Fig. 1 und sind auch mit den gleichen Bezugszeichen versehen.

Besonders deutlich ist in Fig. 2 die erfindungsgemäss koaxiale Ausbildung der Prüfzelle 1 mit der zur bandförmigen Innenleiter 3 flächenparallelen, gleichfalls bandförmigen Potentialplatte 4 zu erkennen. Aufgrund der Flächenparallelität von Innenleiter 3 und Potentialplatte 4 und der elektrischen Verbindung von Potentialplatte 4 und Aussenleiter 2 stellt sich zwischen dem Innenleiter 3 und der Potentialplatte 4 im Bereich des Prüfobjekts 8 in den vom Impulsgenerator 5 in der Prüfzelle 1 erzeugten elektromagnetischen Feldern eine weitgehend homogene Verteilung des elektrischen Feldes ein. Da sich das Prüfobjekt 8 selbst störend auf die Homogenität der elektrischen Feldverteilung auswirkt, sollte seine Höhe H kleiner als der halbe Abstand h zwischen dem Innenleiter 3 und der Potentialplatte 4, besser jedoch noch kleiner als ein Drittel dieses Abstandes sein.

Damit es bei einer typischen NEMP-Feldstärke von 50000 V/m mit Luft unter Normaldruck als Isolationsgas nicht zu Ueberschlägen zwischen dem Innenleiter 3 und der Potentialplatte 4 kommt, sollte ihr Abstand h grösser sein als der kürzeste Abstand a zwischen dem Innenleiter 3 und dem Aussenleiter 2. Durch Verwendung eines Isolationsgases, welches elektronegativer ist als Luft, beispielsweise $SF_6$, lässt sich insbesondere unter Ueberdruck die Durchschlagsfestigkeit der Prüfzelle 1 erheblich steigern. Die Verwendung von komprimierten isolierenden Gasen hat neben der Erhöhung der dielektrischen Festigkeit der Prüfzelle noch einen weiteren Vorteil. Bei Prüfungen mit elektromagnetischen Pulsen kann es nämlich vorkommen, dass auf dem Prüfobjekt selbst die induzierten Spannungen so hohe
Werte annehmen, dass ein elektrischer Ueberschlag zwischen
zwei verschiedenen Stellen auf dem Prüfobjekt oder zwischen
Prüfobjekt und Prüfzelle erfolgt. Solche Ueberschläge
können durch komprimierte isolierende Gase bei Bedarf
unterdrückt werden. Dadurch besteht die Möglichkeit, Durchschlagsphänomene gesondert zu untersuchen.

Die Durchschlagsfestigkeit wird auch durch die Art des
Prüfgases beeinflusst. Durch Ersetzen von trockener Luft
durch trockenes $SF_6$ bei gleichem Druck wird die dielektrische Festigkeit etwa um einen Faktor zwei gesteigert.
Die dielektrische Festigkeit ist in einem weiten Druckbereich
zum Gasdruck etwa proportional. Anstelle von Luft oder
$SF_6$ können mit Vorteil auch Mischmengen verschiedener
Gase verwendet werden, z.B. Stickstoff mit $CO_2$-Zusatz.

Bei einer Auslegung der Prüfzelle 1 für einen mindestens
5-fachen Ueberdruck können Feldstärken bis zu einer Grössenordnung über die typischen NEMP-Feldstärke zwischen dem
Innenleiter 3 und der Potentialplatte 4 erzeugt werden.

Die Eigenschaften der Prüfzelle 1 werden sehr wesentlich
durch die Grösse ihrer charakteristischen Impedanz bestimmt.
Diese sollte zwischen 40 Ohm und 100 Ohm, vorzusgweise
jedoch etwa 70 Ohm betragen. Im genannten Bereich ist
die charakteristische Impedanz näherungsweise eine lineare
Funktion des Verhältnisses der Summe aus der Breite b
und der Dicke d des Innenleiters 3 zum Innendurchmesser
D des Aussenleiters 2. Der Impedanzwert von 40 Ohm entspricht einem Verhältnis von 0,9, der Impedanzwert von
100 Ohm einem Verhältnis von 0,4 und der Impedanzwert
von 70 Ohm einem Verhältnis von 0,6. Vorstehendes gilt
jedoch nur für den Fall, dass die Dicke d des Innenleiters
3 klein gegenüber seiner Breite b ist. Dieses Verhältnis
sollte deshalb nicht grösser als ca. 0,2 sein.

Eine besonders vorteilhafte Ausgestaltung der erfindungsgemässen Einrichtung ergibt sich, wenn die bandförmige
Potentialplatte 4 mit ihren beiden Rändern bündig mit
dem Aussenleiter 2 abschliesst und dadurch den Innenraum
der Prüfzelle 1 in zwei gegeneinander abgeschlossene Teilräume 16 und 17 unterteilt. Die vom Impulsgenerator 5
erzeugten elektromagnetischen Felder können sich dann
lediglich in dem den Innenleiter 3 sowie das Prüfobjekt
8 enthaltenden Teilraum 16, nicht jedoch im Teilraum 17
ausbreiten. Letzterer bleibt feldfrei und bildet dadurch
einen idealen Kabelschacht für die Anschlussleitungen
9, 9.1, 9.2 und 13. Einstreuungen in diese Anschlussleitungen,
verursacht durch die elektromagnetischen Felder im Teilraum
16, lassen sich vermeiden, wenn die Anschlussleitungen,
wie in den Figuren dargestellt, direkt von unten durch
die Potentialplatte 4 in das Prüfobjekt 8 bzw. den Feldstärkesensor 12 geführt sind. In den Durchführungen sämtlicher
Anschlussleitungen durch die Potentialplatte 4 können
zusätzlich in den Figuren nicht dargestellte Filter vorgesehen werden, um Störsignale, die trotz der vorstehend
beschriebenen Massnahme auf den Anschlussleitungen auftreten, zu eliminieren noch bevor sie in den feldfreien Teilraum 17 eindringen können.

Durch Fluten der Prüfzelle mit verschiedenen Gasen, z.B.
mit Luft von verschiedener Feuchtigkeit, auch unter Ueber-
oder Unterdruck, können in vorteilhafter Weise verschiedene
klimatische Bedingungen simuliert werden. Unterdruckuntersuchungen sind z.B. im Hinblick auf elektronische Bauelemente, welche in Flugzeugen eingesetzt werden, von Interesse.

Patentansprüche

1. Einrichtung zur Prüfung elektrischer oder elektronischer Systeme mit elektro-magnetischen Pulsen mit einer gasgefüllten Prüfzelle (1) zur Aufnahme des Prüfobjekts (8), an welche ein Impulsgenerator (5) angeschlossen ist, dadurch gekennzeichnet, dass die Prüfzelle (1) über ihre gesamte Länge als Koaxialleitung mit einem bandförmigen Innenleiter (3) und einem runden Aussenleiter (2) ausgebildet ist, dass flächenparallel zum Innenleiter (3) innerhalb des Aussenleiters (2) in einem mindestens der doppelten Höhe (H) des Prüfobjektes (8) entsprechenden Abstand (h) eine mit dem Aussenleiter (2) verbundene bandförmige Potentialplatte (4) angeordnet ist, dass dieser Abstand (h) grösser als der kürzeste Abstand (a) des Innenleiters (3) vom Aussenleiter (2) ist und dass das Verhältnis der Summe aus der Breite (b) des Innenleiters (3) und seiner Dicke (d) zum Durchmesser (D) des Aussenleiters (2) zwischen 0,4 und 0,9 beträgt.

2. Einrichtung nach Anspruch 1, dadurch gekennzeichnet, dass die Prüfzelle (1) gasdicht und für einen mindestens 5-fachen Ueberdruck oder Vakuum ausgebildet ist.

3. Einrichtung nach Anspruch 1 dadurch gekennzeichnet, dass die Prüfzelle (1) mit einem isolierenden Gas, z.B. $SF_6$, gefüllt ist.

4. Einrichtung nach Anspruch 1, dadurch gekennzeichnet, dass das Verhältnis der Breite (b) des Innenleiters zu seiner Dicke (d) nicht kleiner als 5 ist.

5. Einrichtung nach Anspruch 1, dadurch gekennzeichnet, dass das Verhältnis aus der Summe der Breite (b) des Innenleiters (3) und seiner Dicke (d) zum Durchmesser (D) des Aussenleiters (2) 0,6 beträgt.

6. Einrichtung nach Anspruch 1, dadurch gekennzeichnet, dass die Prüfzelle (1) mit einem ihrer charakteristischen Impedanz entsprechenden Widerstand (6, 7; 6.1, 6.2, 7.1, 7.2) abgeschlossen ist.

7. Einrichtung nach Anspruch 1, dadurch gekennzeichnet, dass in der Prüfzelle (1) mindestens ein Sensor (12) zur Bestimmung der elektrischen und magnetischen Feldstärken angeordnet ist.

8. Einrichtung nach Anspruch 1, dadurch gekennzeichnet, dass der Innenraum der Prüfzelle (1) durch die Potentialplatte (4) in zwei Teilräume (16, 17) unterteilt ist.

9. Einrichtung nach Anspruch 8, dadurch gekennzeichnet, dass die Anschlussleitungen (9; 9.1, 9.2) des Prüfobjektes (8) durch den Aussenleiter (2) in den den Innenleiter (3) nicht enthaltenden Teilraum (17) und von dort durch die Potentialplatte (4) auf dem kürzest möglichen Weg zum Prüfobjekt (8) geführt sind.

10. Einrichtung nach Anspruch 9, dadurch gekennzeichnet, dass im Bereich der Durchführung (10) der Anschlussleitungen (9; 9.1, 9.2) durch die Potentialplatte (4) die Anschlussleitungen (9; 9.1, 9.2) über Filter geführt sind.

FIG.1

FIG.2

Europäisches
Patentamt

**EUROPÄISCHER RECHERCHENBERICHT**

0205747
Nummer der Anmeldung

## EINSCHLÄGIGE DOKUMENTE

EP 86102344.8

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | IEEE TRANSACTIONS ON ELECTROMAGNE-TIC COMPATIBILITY, Vol. EMC-20, Nr. 1, Feber 1978<br><br>C.BAUM "EMP Simulators for Various Types of Nuclear EMP Environments: An Interim Categorization"<br>Seiten 35-53<br><br>* Seite 39; fig. 4C *<br><br>----  | 1 | G 01 R 31/16 |

RECHERCHIERTE
SACHGEBIETE (Int. Cl.4)

G 01 R 31/00

Der vorliegende Recherchenbericht wurde für alle Patentansprüche erstellt.

| Recherchenort | Abschlußdatum der Recherche | Prüfer |
|---|---|---|
| WIEN | 29-09-1986 | KUNZE |